# EUROPÄISCHE PATENTSCHRIFT

(11) **EP 3 194 911 B1**
(45) Veröffentlichungstag und Bekanntmachung des Hinweises auf die Patenterteilung: **15.12.2021**
(21) Anmeldenummer: 15754194.7
(22) Anmeldetag: 21.08.2015
(51) Int. Cl.: G01F 23/296, G08B 21/00, H01F 27/12, H01H 9/00, G01R 31/12

(54) **ELEKTROGERÄT MIT EINEM MIT ISOLIERÖL GEFÜLLTEN GEHÄUSE SOWIE MESSGERÄT UND VERFAHREN ZUM ÜBERWACHEN EINES SOLCHEN ELEKTROGERÄTS**
ELECTRONIC DEVICE WITH A HOUSING FILLED WITH INSULATING OIL, AND DEVICE AND METHOD FOR SUPERVISING THE ELECTRONIC DEVICE
DISPOSITIF ÉLECTRIQUE AVEC UN BOÎTIER REMPLI D'HUILE ISOLANTE, ET APPAREIL ET PROCÉDÉ DE SURVEILLANCE POUR CE DISPOSITIF ÉLECTRIQUE

(30) Priorität: 18.09.2014 DE 102014113470
(43) Veröffentlichungstag der Anmeldung: 26.07.2017
(73) Patentinhaber: Maschinenfabrik Reinhausen GmbH, 93059 Regensburg (DE)
(72) Erfinder: SAVELIEV, Anatoli, 93197 Zeitlarn (DE); HOCHMUTH, Harald, 93149 Nittenau (DE)
(86) Internationale Anmeldenummer: PCT/EP2015/069243
(87) Internationale Veröffentlichungsnummer: WO 2016/041735

(56) Entgegenhaltungen:
- DE-A1- 3 516 200
- DE-T2- 60 025 927
- US-A- 3 110 890
- US-A1- 2004 046 568
- US-A1- 2011 257 924
- US-A1- 2014 133 054
- US-A1- 2014 172 327

## Beschreibung

Die Erfindung betrifft ein Elektrogerät mit einem mit Isolieröl gefüllten Gehäuse, insbesondere einen Leistungstransformator, eine Kompensationsdrossel oder einen Laststufenschalter, sowie ein Messgerät und ein Verfahren zum Überwachen eines solchen Elektrogeräts.

RU 2 205 372 C1 beschreibt ein Gerät zum Ermitteln des Füllstands einer Flüssigkeit in einem Behälter. Dieses Gerät umfasst einen piezoelektrischen Wandler 1, der akustisch an die Wand des Behälters gekoppelt ist, einen ersten Detektor 2, einen Anpassungstransformator 3, einen ersten Kondensator C1, ein HF-Kabel 4, einen zweiten Kondensator C2, einen Wobbelgenerator 5, einen zweiten Detektor 6, einen dritten Kondensator C3, einen Verstärker 7, zwei Komparatoren 8 und 9 und eine Anzeigeeinheit 10. Die Mittenfrequenz des Wobbelgenerators entspricht der Resonanz, wenn die Wanddicke eine ganze Anzahl von Halbwellen der akustischen Schwingungen ist. Unter dieser Bedingung hängt die maximale Amplitude der Schwingungen der Schaltung, die aus der Sekundärwicklung des Anpassungstransformators und der Kapazität des piezoelektrischen Elements besteht, abhängig von der Anwesenheit oder Abwesenheit von Flüssigkeit hinter der Wand. Dieses bekannte Gerät ist sehr aufwändig gebaut, ungenau und temperaturabhängig.

Geräte zum Ermitteln des Füllstands einer Flüssigkeit in einem Behälter mit Hilfe von piezoelektrischen Wandlern sind zudem aus DE 35 16 200 A1 und US 3 110 890 A bekannt. Systeme zum Überwachen von Hochspannungstransformatoren zwecks Erkennung von Teilentladungen mit Hilfe von Ultraschallmessaufnehmern sind aus DE 600 25 927 T2, US 2004/0046568 A1 und US 2014/0172327 A1 bekannt.

Es ist Aufgabe der Erfindung, bei einem Elektrogerät mit einem mit Isolieröl gefüllten Gehäuse sowie einem Messgerät und einem Verfahren zum Überwachen eines solchen Elektrogeräts die Temperaturabhängigkeit der Überwachung zu verringern und die Genauigkeit der Überwachung zu erhöhen.

Diese Aufgabe wird durch die Gegenstände der unabhängigen Ansprüche gelöst. Vorteilhafte Weiterbildungen und Ausführungsformen der Erfindung sind in den abhängigen Ansprüchen beschrieben.

Die Erfindung schlägt ein Messgerät zum Überwachen eines Elektrogeräts vor, das ein mit Isolieröl gefülltes oder befüllbares Gehäuse umfasst;
das Messgerät umfassend
- ein Piezoelement, das in dem Gehäuse auf Höhe eines Mindestfüllstands des Isolieröls angeordnet ist; und
- eine Auswerteeinrichtung umfasst, die an das Piezoelement angeschlossen ist;
wobei
- die Auswerteeinrichtung derart ausgebildet ist, dass sie
   - das Piezoelement zu einer Schwingung anregen kann;
   - den Messwert einer von dem Füllstand abhängigen Messgröße der Schwingung, insbesondere die Halbwertszeit der Amplitude der Schwingung, ermitteln kann;
wobei die Auswerteeinrichtung derart ausgebildet ist, dass sie zur akustischen Überwachung des Elektrogeräts während zumindest eines Teils des Zeitintervalls, in dem sie das Piezoelement nicht anregt, die Schwingung des Piezoelements erfasst.

Das vorgeschlagene Messgerät ist sehr einfach aufgebaut und ermöglicht eine Überwachung mit hoher Genauigkeit und niedriger Temperaturabhängigkeit.

Die Erfindung schlägt zudem ein Elektrogerät mit einem derartigen Messgerät vor. Das vorgeschlagene Elektrogerät kann nach Bedarf auf beliebige Art und Weise ausgebildet sein, beispielsweise
- als Leistungstransformator oder Kompensationsdrossel oder Laststufenschalter; und/oder
- derart, dass es wenigstens ein oder kein zusätzliches Messgerät umfasst.

Es kann vorgesehen sein, dass die Auswerteeinrichtung derart ausgebildet ist, dass sie zur Überwachung des Mindestfüllstands
- den Messwert mit einem vorbestimmten Schwellenwert vergleicht;
- falls der Messwert größer als dieser Schwellenwert ist, ein Alarmsignal erzeugt.

Es kann vorgesehen sein, dass die Auswerteeinrichtung außerhalb des Gehäuses oder neben dem Gehäuse angeordnet ist.

Es kann vorgesehen sein, dass das Piezoelement an der Unterseite eines Deckels des Gehäuses angebracht ist.

Es kann vorgesehen sein, dass das Messgerät eine Antenne umfasst, die in dem Gehäuse angeordnet und an die Auswerteeinrichtung angeschlossen ist.

Es kann vorgesehen sein, dass die Auswerteeinrichtung derart ausgebildet ist, dass sie zur Entladungsüberwachung
- die Amplitude des von der Antenne erzeugten Antennensignals mit einem vorbestimmten Schwellenwert vergleicht;
- falls die Amplitude größer als dieser Schwellenwert ist, ein Alarmsignal erzeugt.

Es kann vorgesehen sein, dass die Auswerteeinrichtung derart ausgebildet ist, dass sie zur Entladungslokalisation
- die Amplitude des von der Antenne erzeugten Antennensignals mit einem vorbestimmten Schwellenwert vergleicht und insbesondere das Antennensignal erfasst;
- falls die Amplitude des Antennensignals größer als dieser Schwellenwert ist, die Schwingung des Piezoelements erfasst und insbesondere auswertet und insbesondere auch das Antennensignal auswertet.

Es kann vorgesehen sein, dass die Auswerteeinrichtung derart ausgebildet ist, dass sie
- die Amplitude der Schwingung mit einem vorbestimmten Schwellenwert vergleicht;
- falls die Amplitude der Schwingung größer als dieser Schwellenwert ist, eine Laufzeit als Differenz zwischen dem Zeitpunkt, zu dem die Amplitude der Schwingung größer als der zugeordnete Schwellenwert ist, und dem Zeitpunkt, zu dem die Amplitude des Antennensignals größer als der zugeordnete Schwellenwert ist, ermittelt und aus dieser Laufzeit ein Lokalisationssignal erzeugt.

Es kann vorgesehen sein, dass die Anregung des Piezoelements bei dessen Resonanzfrequenz erfolgt.

Es kann vorgesehen sein, dass das Messgerät wenigstens einen Temperatursensor umfasst, der in dem Gehäuse angeordnet und an die Auswerteeinrichtung angeschlossen ist.

Jedes Elektrogerät kann nach Bedarf auf beliebige Art und Weise ausgebildet sein und beispielsweise wenigstens ein oder kein zusätzliches Gehäuse und/oder wenigstens ein oder kein zusätzliches Messgerät umfassen.

Es kann vorgesehen sein, dass das Messgerät ein Kabel umfasst, über das die Auswerteeinrichtung an das Piezoelement angeschlossen ist.

Es kann vorgesehen sein, dass das Piezoelement zusammen mit der Antenne und/oder dem Temperatursensor in einem gemeinsamen Messgehäuse angeordnet oder aufgenommen ist.

Es kann vorgesehen sein, dass das Piezoelement eine Oberseite hat, die zumindest teilweise konvex ist und/oder zumindest teilweise plan und nicht waagerecht ist und/oder zumindest teilweise plan und waagerecht ist und/oder zumindest teilweise konkav ist und/oder wenigstens oder genau einen Ablauf für Isolieröl aufweist.

Durch diesen Ablauf kann, falls der Mindestfüllstand erreicht oder unterschritten wird, das möglicherweise auf der Oberseite des Piezoelements noch verbliebene oder stehende Isolieröl ablaufen. Der Ablauf kann nach Bedarf auf beliebige Art und Weise ausgebildet sein und beispielsweise wenigstens oder genau eine Ablauföffnung und/oder wenigstens oder genau ein Ablaufloch und/oder wenigstens oder genau eine Ablaufnut und/oder wenigstens oder genau einen Ablaufschlitz umfassen.

Vorzugsweise
- ist wenigstens eine der Antennen und/oder wenigstens einer der Temperatursensoren in unmittelbarer Nähe wenigstens eines der Piezoelemente angeordnet oder an wenigstens einem der Piezoelemente angebracht.

Die Erfindung schlägt zudem ein Verfahren zum Uberwachen eines Elektrogeräts vor, wobei das Elektrogerät
- ein mit Isolieröl gefülltes oder befüllbares Gehäuse und
- ein Messgerät umfasst, das
   - ein Piezoelement umfasst, das in dem Gehäuse auf Höhe eines Mindestfüllstands des Isolieröls angeordnet ist;
umfassend die Schritte, dass
- das Piezoelement zu einer Schwingung angeregt wird;
- der Messwert einer von dem Füllstand abhängigen Messgröße der Schwingung, insbesondere die Halbwertszeit der Amplitude der Schwingung, ermittelt;
wobei zur akustischen Überwachung des Elektrogeräts während zumindest eines Teils des Zeitintervalls, in dem das Piezoelement nicht angeregt wird, die Schwingung des Piezoelements erfasst wird.

Das gemäß diesem Aspekt vorgeschlagene Verfahren ermöglicht eine Überwachung mit hoher Genauigkeit und niedriger Temperaturabhängigkeit.

Vorzugsweise kann jedes der vorgeschlagenen Elektrogeräte und Messgeräte derart ausgebildet sein und/oder dazu dienen und/oder dafür geeignet sein, dass es das vorgeschlagene Verfahren ausführt und/oder ausführen kann.

Jedes Messgerät kann nach Bedarf auf beliebige Art und Weise ausgebildet sein und beispielsweise wenigstens ein oder kein zusätzliches Piezoelement und/oder wenigstens eine oder keine zusätzliche Auswerteeinrichtung und/oder wenigstens ein oder kein zusätzliches Kabel und/oder wenigstens eine oder keine zusätzliche Antenne und/oder wenigstens einen oder keinen zusätzlichen Temperatursensor umfassen.

Jedes Piezoelement kann nach Bedarf auf beliebige Art und Weise ausgebildet sein, beispielsweise derart, dass es eine Resonanzfrequenz zwischen 100 kHz und 10 MHz oder zwischen 200 kHz und 5 MHz oder zwischen 500 kHz und 2 MHz oder zwischen 700 kHz und 1,5 MHz oder von 500 kHz oder von 750 kHz oder von 1 MHz oder von 1,5 MHz oder von 2 MHz oder von 3 MHz oder von 5 MHz hat.

Die Anregung des Piezoelements kann nach Bedarf auf beliebige Art und Weise erfolgen, beispielsweise mit wenigstens einem Burst-Signal, dessen Hauptfrequenz der Resonanzfrequenz des Piezoelements entspricht, und/oder mit wenigstens einem Burst-Signal, dessen Hauptfrequenz nicht der Resonanzfrequenz des Piezoelements entspricht, und/oder mit wenigstens einem Dirac-Impuls und/oder mit wenigstens einem RechteckImpuls und/oder mit wenigstens einem breitbandigen Signal, das die Resonanzfrequenz und/oder wenigstens eine andere Frequenz enthält.

Die Hauptfrequenz des Burst-Signal kann nach Bedarf beliebig gewählt sein und beispielsweise um einen vorbestimmten Differenzbetrag oder ein vorbestimmtes Verhältnis von der Resonanzfrequenz nach oben oder unten abweichen. Vorzugsweise ist der vorbestimmte Differenzbetrag größer oder gleich einem Wert, der beispielsweise 10 kHz oder 20 kHz oder 50 kHz oder 100 kHz oder 200 kHz oder 500 kHz beträgt. Vorzugsweise ist das vorbestimmte Verhältnis größer oder gleich einem ersten Wert und/oder kleiner oder gleich einem zweiten Wert und beträgt der erste Wert beispielsweise 5 % oder 7 % oder 10 % oder 15 % oder 20 % oder 35 % und der zweite Wert beispielsweise 5 % oder 7 % oder 10 % oder 15 % oder 20 % oder 35 %

Jedes Kabel kann nach Bedarf auf beliebige Art und Weise ausgebildet sein, beispielsweise als Twisted-Pair-Kabel, und/oder beispielsweise wenigstens oder genau zwei Adern umfassen und/oder beispielsweise wenigstens 3 m oder wenigstens 4 m oder wenigstens 5 m oder wenigstens 6 m oder wenigstens 8 m oder wenigstens 10 m lang oder wenigstens 15 m lang oder wenigstens 20 m lang oder wenigstens 30 m lang sein.

Jede Antenne kann nach Bedarf auf beliebige Art und Weise ausgebildet sein, beispielsweise als elektrische Antenne oder als magnetische Antenne oder als Ferritstabantenne oder als Dipolantenne, und/oder beispielsweise wenigstens oder genau eine Spule und/oder wenigstens oder genau einen Kondensator umfassen.

Jedes Vergleichen der Amplitude kann nach Bedarf auf beliebige Art und Weise erfolgen, beispielsweise derart, dass sie mit wenigstens einem zusätzlichen vorbestimmten Schwellenwert verglichen wird.

Im Folgenden werden Ausführungsformen der Erfindung beispielhaft anhand der beigefügten Zeichnungen näher erläutert. Die daraus hervorgehenden einzelnen Merkmale sind jedoch nicht auf die einzelnen Ausführungsformen beschränkt, sondern können mit weiter oben beschriebenen einzelnen Merkmalen und/oder mit einzelnen Merkmalen anderer Ausführungsformen verbunden und/oder kombiniert werden. Die Einzelheiten in den Zeichnungen sind nur erläuternd, nicht aber beschränkend auszulegen. Die in den Ansprüchen enthaltenen Bezugszeichen sollen den Schutzbereich der Erfindung in keiner Weise beschränken, sondern verweisen lediglich auf die in den Zeichnungen gezeigten Ausführungsformen.

Die Zeichnungen zeigen in
- FIG. 1: eine erste Ausführungsform eines Elektrogeräts mit einem mit Isolieröl gefüllten Gehäuse und einer ersten Ausführungsform eines Messgeräts;
- FIG. 2: eine zweite Ausführungsform des Elektrogeräts mit einer zweiten Ausführungsform des Messgeräts;
- FIG. 3: einen Teil einer dritten Ausführungsform des Messgeräts in einer Seitenansicht;
- FIG. 4: eine Explosionsansicht zu FIG. 3;
- FIG. 5: einen Schnitt längs der Linie V-V aus FIG. 3;
- FIG. 6: das vergrößerte Detail VI aus FIG. 5.

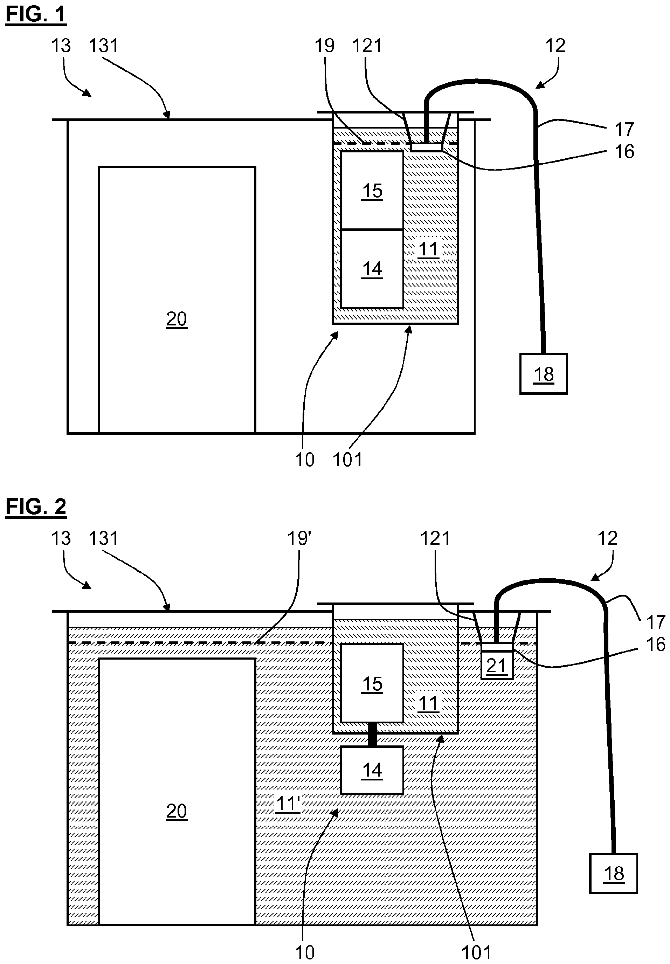

In FIG. 1 ist eine erste Ausführungsform eines Elektrogeräts 10 schematisch dargestellt, das ein Gehäuse 101, das mit Isolieröl 11 gefüllt oder befüllbar ist, und ein Messgerät 12 umfasst und beispielhaft einen Laststufenschalter 10 für einen Leistungstransformator 13 bildet.

Bei dieser Ausführungsform umfasst das Elektrogerät beziehungsweise der Laststufenschalter 10 einen Wähler 14, der innerhalb des Gehäuses 101, das nachfolgend auch als Schaltergehäuse 101 bezeichnet wird, in einem unteren Bereich angeordnet ist, und einen Lastumschalter 15, der innerhalb des Schaltergehäuses 101 in einem oberen Bereich angeordnet ist. Vorzugsweise ist der Laststufenschalter 10 als Lastwähler ausgebildet, bei dem Wähler 14 und Lastumschalter 15 in einer Lastwählereinheit zusammengefasst sind.

Das Messgerät 12 ist gemäß einer ersten Ausführungsform ausgebildet.

Bei dieser Ausführungsform umfasst das Messgerät 12 ein Messgehäuse 121, ein Piezoelement 16, ein Kabel 17 und eine Auswerteeinrichtung 18, die über das Kabel 17 an das Piezoelement 16 angeschlossen ist. Das Piezoelement 16 ist in dem Schaltergehäuse 101 auf Höhe eines Mindestfüllstands 19 des Isolieröls 11 angeordnet und hat beispielhaft eine Resonanzfrequenz von 1 MHz. Das Messgehäuse 121 ist mit seinem oberen Ende an der Unterseite eines Deckels des Schaltergehäuses 101 angebracht, nimmt in seinem unteren Ende das Piezoelement 16 auf und ist öldurchlässig, sodass das Isolieröl 11 bei ausreichendem Füllstand das Piezoelement 16 zumindest teilweise und bevorzugt möglichst vollständig umgeben kann. Das Messgehäuse 121 hat beispielsweise mehrere Durchbrüche für das Isolieröl 11 und/oder umfasst ein Gestell aus miteinander verbundenen Stangen und/oder wenigstens ein Gitter und/oder wenigstens ein Netz.

Das Kabel 17 ist beispielhaft ein geschirmtes Twisted-Pair-Kabel (STP-Kabel) mit beispielhaft wenigstens zwei, insbesondere genau zwei Adern, und die Auswerteeinrichtung 18 ist beispielhaft neben dem Transformatorgehäuse 131 und somit neben dem Schaltergehäuse 101 angeordnet.

Die Auswerteeinrichtung 18 ist derart ausgebildet, dass sie das Piezoelement 16 zu einer Schwingung anregen kann und die Halbwertszeit der Amplitude der Schwingung ermitteln kann. Diese Halbwertszeit hängt von der Dämpfung der Schwingung ab. Diese Dämpfung hängt von dem an das Piezoelement 16 angrenzenden Medium ab, das für einen ersten Fall, dass die Oberfläche des Isolieröls 11 im Schaltergehäuse 101 beim Mindestfüllstand 19 oder darüber liegt, das Isolieröl 11 ist und für einen zweiten Fall, dass die Oberfläche des Isolieröls 11 unter dem Mindestfüllstand 19 liegt, zumindest teilweise Luft ist. Im ersten Fall ist die Dämpfung größer als im zweiten Fall, da das Isolieröl 11 im Vergleich zu Luft eine größere Dichte hat. Daher ist die Halbwertszeit im ersten Fall kleiner als im zweiten Fall und hängt folglich von dem Füllstand ab. Somit stellt diese Halbwertszeit beispielhaft einen Messwert einer von dem Füllstand abhängigen Messgröße der Schwingung dar.

Die Auswerteeinrichtung 18 ist derart ausgebildet ist, dass sie zur Überwachung des Mindestfüllstands 19 den Messwert mit beispielhaft genau einem vorbestimmten ersten Schwellenwert vergleicht und, falls der Messwert größer als dieser Schwellenwert ist, ein entsprechendes erstes Alarmsignal erzeugt. Dies erfolgt beispielhaft dadurch, dass sie die Halbwertszeit mit einem vorbestimmten ersten Schwellenwert vergleicht und, falls die Halbwertszeit größer als dieser Schwellenwert ist, das erste Alarmsignal erzeugt. Der erste Schwellenwert entspricht dabei der Halbwertszeit einer Schwingung des Piezoelements 16, dessen Oberfläche zumindest teilweise und insbesondere vollständig nicht an Isolieröl 11, sondern an Luft grenzt.

Die Anregung erfolgt beispielhaft mit einem Burst-Signal, dessen Frequenz der Resonanzfrequenz des Piezoelements 16 entspricht.

In FIG. 2 ist eine zweite Ausführungsform des Elektrogeräts 13 schematisch dargestellt, das ein Gehäuse 131, das mit Isolieröl 11' gefüllt oder befüllbar ist, das Messgerät 12 und ein Aktivteil 20 mit einem nicht dargestellten Kern und nicht dargestellten Wicklungen umfasst und beispielhaft einen Leistungstransformator 13 bildet. Diese Ausführungsform ähnelt der ersten Ausführungsform, sodass im Folgenden vor Allem die Unterschiede näher erläutert werden.

Bei dieser Ausführungsform umfasst das Elektrogerät beziehungsweise der Leistungstransformator 13 den Laststufenschalter 10, der innerhalb des Gehäuses 131, das nachfolgend auch als Transformatorgehäuse 131 bezeichnet wird, in einem ersten Bereich angeordnet ist. Das Aktivteil 20 ist innerhalb des Transformatorgehäuses 131 in einem zweiten Bereich angeordnet. Der erste Bereich grenzt an eine erste Seitenwand (rechts in FIG. 2) des Transformatorgehäuses 131 an, der zweite Bereich grenzt an eine zweite Seitenwand (links in FIG. 2) des Transformatorgehäuses 131 an, die der ersten Seitenwand gegenüberliegt.

Der Laststufenschalter 10 ist als Lastschalter ausgebildet, bei dem Wähler 14 und Lastumschalter 15 separate Einheiten bilden, die über eine Schaltwelle mechanisch und über nicht dargestellte Verbindungskabel elektrisch miteinander verbunden sind. Der Wähler 14 ist nicht wie bei der ersten Ausführungsform innerhalb, sondern außerhalb des Schaltergehäuses 101 und innerhalb des Transformatorgehäuses 131 angeordnet, und die Schaltwelle und die nicht dargestellten Verbindungskabel sind durch das Schaltergehäuse 101 in das Transformatorgehäuse 131 geführt.

Das Messgerät 12 ist gemäß einer zweiten Ausführungsform ausgebildet. Diese Ausführungsform ähnelt der ersten Ausführungsform, sodass im Folgenden vor Allem die Unterschiede näher erläutert werden.

Bei dieser Ausführungsform ist das Piezoelement 16 in dem Transformatorgehäuse 131 in dem zweiten Bereich zwischen Laststufenschalter 10 und zweiter Seitenwand auf Höhe eines Mindestfüllstands 19' des Isolieröls 11' angeordnet. Das Messgehäuse 121 ist mit seinem oberen Ende an der Unterseite eines Deckels des Transformatorgehäuses 131 angebracht und ist öldurchlässig, sodass das Isolieröl 11' bei ausreichendem Füllstand das Piezoelement 16 zumindest teilweise und bevorzugt möglichst vollständig umgeben kann.

Das Messgerät 12 umfasst eine Antenne 21, die beispielhaft an dem Messgehäuse 121 unterhalb des Piezoelements 16 angebracht und über das Kabel 17 an die Auswerteeinrichtung 18 angeschlossen ist. Das Kabel 17 umfasst dementsprechend beispielhaft wenigstens zwei, insbesondere genau zwei zusätzliche Adern für die Antenne 21.

Die Auswerteeinrichtung 18 ist derart ausgebildet, dass sie zur akustischen Überwachung des Leistungstransformators 13 während zumindest eines Teils des Zeitintervalls, in dem sie das Piezoelement 16 nicht angeregt, die Schwingung des Piezoelements 16 erfasst und ausgewertet werden. Das Piezoelement 16 dient dann als Mikrofon für in dem Leistungstransformator 13 erzeugte und durch das Isolieröl 11' übertragene Schallwellen, die diese Schwingung bewirken.

Die Auswerteeinrichtung 18 ist derart ausgebildet, dass sie zur Entladungsüberwachung die Amplitude des von der Antenne 21 erzeugten Antennensignals mit einem vorbestimmten zweiten Schwellenwert vergleicht und, falls die Amplitude größer als dieser Schwellenwert ist, ein entsprechendes zweites Alarmsignal erzeugt, das eine geringe Wahrscheinlichkeit einer Entladung in dem Leistungstransformator 13 anzeigt.

Die Auswerteeinrichtung 18 ist außerdem derart ausgebildet, dass sie, falls die Amplitude größer als der zweite Schwellenwert ist, die Schwingung des Piezoelements erfasst. Das Erfassen dieser Schwingung erfolgt ohne vorherige Anregung des Piezoelements 16, sodass das Piezoelement 16 als Mikrofon für in dem Leistungstransformator 13 erzeugte und durch das Isolieröl 11' übertragene Schallwellen dient, die diese Schwingung bewirken. Falls die Amplitude dieser Schwingung größer als ein dritter Schwellenwert ist, dann ermittelt die Auswerteeinrichtung 18 eine Laufzeit der Schallwellen als Differenz zwischen dem Zeitpunkt, zu dem die Amplitude der Schwingung größer als der dritte Schwellenwert ist, und dem Zeitpunkt, zu dem die Amplitude des Antennensignals größer als der zweite Schwellenwert ist. Falls diese Laufzeit in einem vorbestimmten Intervall, das von der Lage des Piezoelements 16 und den Abmessungen des Leistungstransformators 13 abhängt, liegt, dann erzeugt die Auswerteeinrichtung 18 ein drittes Alarmsignal, das eine hohe Wahrscheinlichkeit einer Entladung in dem Leistungstransformator 13 anzeigt.

Die Auswerteeinrichtung 18 ist derart ausgebildet ist, dass sie zur Entladungslokalisation die Amplitude des von der Antenne 21 erzeugten Antennensignals mit einem vorbestimmten vierten Schwellenwert vergleicht und, falls die Amplitude größer als dieser Schwellenwert ist, die Schwingung des Piezoelements erfasst. Das Erfassen dieser Schwingung erfolgt ohne vorherige Anregung des Piezoelements 16. Falls die Amplitude dieser Schwingung größer als ein fünfter Schwellenwert ist, dann ermittelt die Auswerteeinrichtung 18 eine Laufzeit der Schallwellen als Differenz zwischen dem Zeitpunkt, zu dem die Amplitude der Schwingung größer als der fünfte Schwellenwert ist, und dem Zeitpunkt, zu dem die Amplitude des Antennensignals größer als der vierte Schwellenwert ist. Falls diese Laufzeit in einem vorbestimmten ersten Intervall, das von dem Abstand zwischen dem Piezoelement 16 und einer möglichen ersten Entladungsquelle innerhalb des Leistungstransformators 13 abhängt, liegt, dann erzeugt die Auswerteeinrichtung 18 ein erstes Lokalisationssignal, das eine Entladung bei der ersten Entladungsquelle anzeigt. Falls diese Laufzeit in einem vorbestimmten zweiten Intervall, das von dem Abstand zwischen dem Piezoelement 16 und einer möglichen zweiten Entladungsquelle innerhalb des Leistungstransformators 13 abhängt, liegt, dann erzeugt die Auswerteeinrichtung 18 ein zweites Lokalisationssignal, das eine Entladung bei der zweiten Entladungsquelle anzeigt. Beispielhaft ist die erste Entladungsquelle der Wähler 14 und die zweite Entladungsquelle das Aktivteil 20. Da bei dieser Ausführungsform das Aktivteil 20 vom Piezoelement 16 weiter entfernt ist als der Wähler 14, ist die Untergrenze des zweiten Intervalls größer oder gleich der Obergrenze des ersten Intervalls gewählt.

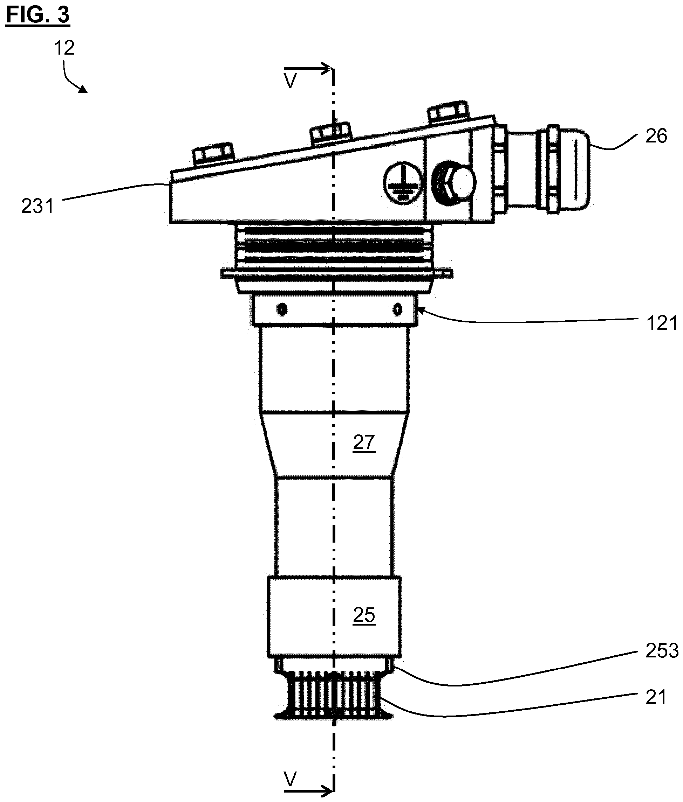

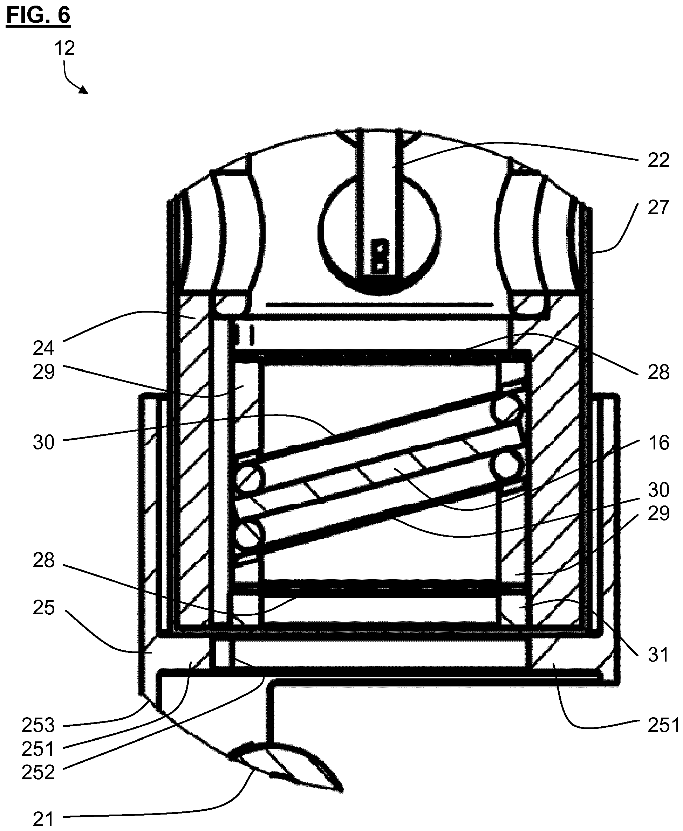

In FIG. 3, FIG. 4, FIG. 5 und FIG. 6 ist ein Teil einer dritten Ausführungsform des Messgeräts 12 schematisch dargestellt. Diese Ausführungsform ähnelt der zweiten Ausführungsform, sodass im Folgenden vor Allem die Unterschiede näher erläutert werden.

Bei dieser Ausführungsform umfasst die Antenne 21 beispielhaft eine Spule und das Messgerät 12 einen Temperatursensor 22, der beispielhaft an dem Messgehäuse 121 oberhalb des Piezoelements 16 angebracht und über das nicht dargestellte Kabel 17 an die Auswerteeinrichtung 18 angeschlossen ist. Das Kabel 17 umfasst dementsprechend beispielhaft wenigstens zwei, insbesondere genau zwei zusätzliche Adern für den Temperatursensor 22.

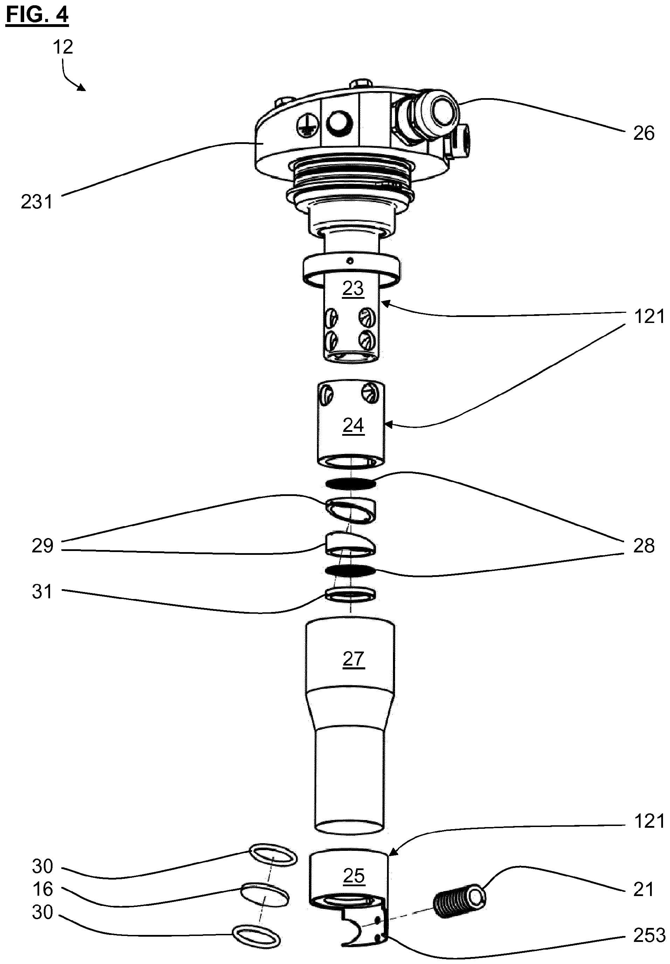

Das Messgehäuse 121 ist beispielhaft dreiteilig ausgebildet und umfasst ein oberes Gehäuseteil 23 (oben in FIG. 4) mit einem Gehäusekopf 231 an seinem oberen Ende, ein im Wesentlichen rohrförmiges mittleres Gehäuseteil 24 (mittig in FIG. 4) und ein im Wesentlichen rohrförmiges unteres Gehäuseteil 25 (unten in FIG. 4) mit einem kreisringförmigen Kragen 251, wenigstens einem zahnartigen Anschlag 252 und einer Antennenhalterung 253. Die Gehäuseteile 23-25 sind elektrisch isolierend.

Das obere Gehäuseteil 23 ist durch den nicht dargestellten Deckel des Transformatorgehäuses 131 geführt und an diesem befestigt, sodass der im Wesentlichen rohrförmige untere Endabschnitt des oberen Gehäuseteils 23 innerhalb des Transformatorgehäuses 131 und der Gehäusekopf 231 außerhalb des Transformatorgehäuses 131 liegt. Der Gehäusekopf 231 umfasst eine Kabeldurchführung 26 für das Kabel 17. Der Temperatursensor 22 verläuft durch den unteren Endabschnitt des oberen Gehäuseteils 23.

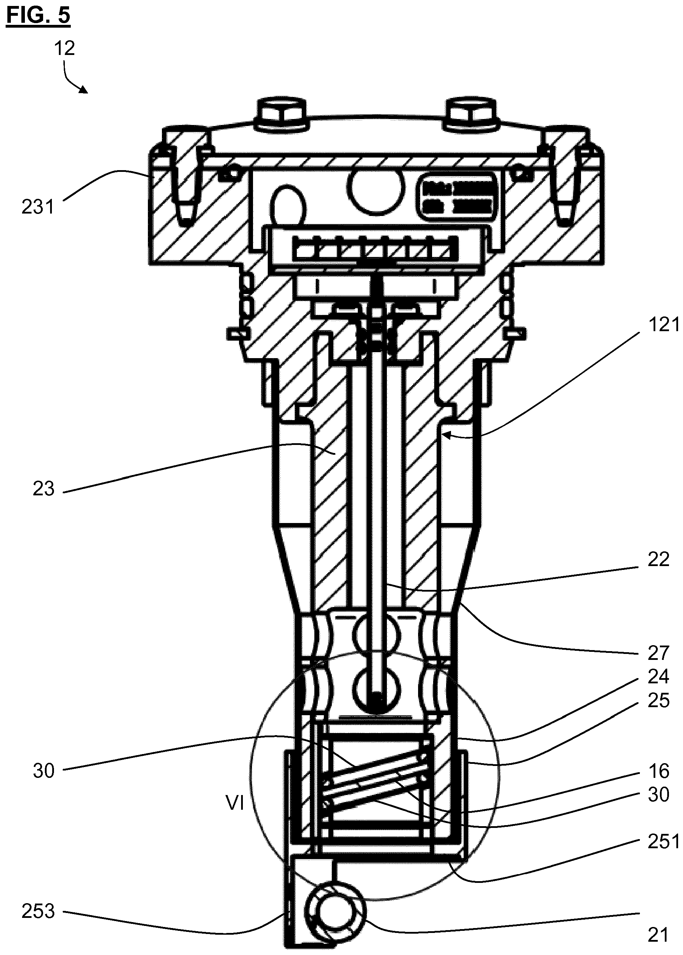

Das Messgerät 12 umfasst ein äußeres Abschirmelement 27, zwei innere Abschirmelemente 28, zwei keilförmige Halteringe 29, zwei O-Ringe 30 und einen Stützring 31. Das äußere Abschirmelement 27 umfasst beispielhaft ein Rohr oder einen Schlauch aus einem elektrisch leitfähigen Gitter oder Netz und ist somit öldurchlässig. Es ist mit seinem oberen Ende am oberen Ende des unteren Endabschnitts des oberen Gehäuseteils 23 befestigt und nimmt diesen Endabschnitt mit seinem oberen Endabschnitt und mit seinem unteren Endabschnitt das mittlere Gehäuseteil 24 auf. Das mittlere Gehäuseteil 24 nimmt das erste innere Abschirmelement 28, den ersten Haltering 29, den ersten O-Ring 30, das Piezoelement 16, den zweiten O-Ring 30, den zweiten Haltering 29, das zweite innere Abschirmelement 28 und den Stützring 31 in dieser Reihenfolge (von oben nach unten in FIG. 4, 5) auf. Das untere Gehäuseteil 25 hat beispielhaft eine kreiszylindrische Umfangswand und an deren unteren Rand den radial einwärts vorstehenden Kragen 251. Von dem inneren Rand dieses Kragens 251 steht radial der Anschlag 252 vor. Von dem unteren Ende der Umfangswand steht die Antennenhalterung 253 axial nach unten vor, an der die Spule der Antenne 21 befestigt ist. Das untere Gehäuseteil 25 nimmt den unteren Endabschnitt des äußeren Abschirmelements 27 auf.

Das Piezoelement 16 ist beispielhaft eine Kreisscheibe und hat somit eine plane Oberseite und eine plane Unterseite. An der Oberseite liegt der erste O-Ring 30 an, und an der Unterseite liegt der zweite O-Ring 30 an. Jeder Haltering 29 hat beispielhaft eine kreiszylindrische äußere Umfangsfläche, eine kreisförmige, erste Stirnfläche und eine elliptische, zweite Stirnfläche, sodass er von der Seite wie ein Keil aussieht (FIG. 4-6). Jeder Haltering 29 liegt mit seiner zweiten Stirnfläche an dem jeweiligen O-Ring 30 an. Jedes innere Abschirmelement 28 umfasst beispielhaft eine Kreisscheibe oder Kreisplatte aus einem elektrisch leitfähigen Gitter oder Netz und ist somit öldurchlässig. Es liegt mit einer Seite an der ersten Stirnfläche des jeweiligen Halterings 29 an. Das erste innere Abschirmelement 28 liegt mit seiner anderen Seite, nämlich der Oberseite, an der unteren Stirnfläche des unteren Endabschnitts des oberen Gehäuseteils 23 an. Der Stützring 31 hat beispielhaft eine kreiszylindrische äußere Umfangsfläche und zwei kreisförmige Stirnflächen. Das zweite innere Abschirmelement 28 liegt mit seiner anderen Seite, nämlich der Unterseite, an der oberen Stirnfläche des Stützrings 31 an. Der Stützring 31 liegt mit seiner unteren Stirnfläche an dem Anschlag 252 an. Das mittlere Gehäuseteil 24 liegt mit seiner unteren Stirnfläche an dem Kragen 251 an.

Da das Piezoelement 16 schräg zwischen den elliptischen, zweiten Stirnflächen der Halteringe 29 eingeklemmt ist, ist seine Oberseite nicht waagerecht, wenn das Piezoelement 16 ordnungsgemäß in das Messgehäuse 121 und das Messgehäuse 121 ordnungsgemäß in den Leistungstransformator 13 eingebaut ist. Der erste O-Ring 30 hat bevorzugt an seiner tiefsten Stelle einen nicht dargestellten Schlitz, der einen Ablauf für Isolieröl 11' bildet, durch den auf der Oberseite des Piezoelements 16 verbliebenes Isolieröl 11' ablaufen kann, falls der Mindestfüllstand 19' erreicht oder unterschritten wird.

Alternativ oder zusätzlich kann das Piezoelement 16 selbst einen Ablauf für Isolieröl 11' aufweisen, der beispielhaft eine Ablauföffnung, ein Ablaufloch, eine Ablaufnut oder ein Ablaufschlitz sein kann. Alternativ oder zusätzlich kann zwischen Piezoelement 16 und dem ersten O-Ring 30 eine Zahnscheibe mit axial zum Piezoelement 16 vorstehenden Zähnen angeordnet sind, zwischen denen das Isolieröl 11' ablaufen kann.

### BEZUGSZEICHEN

- 10: Laststufenschalter, Elektrogerät
- 101: Schaltergehäuse, Gehäuse von 10
- 11, 11': Isolieröl in 101, 131
- 12: Messgerät
- 121: Messgehäuse von 12
- 13: Leistungstransformator, Elektrogerät
- 131: Transformatorgehäuse, Gehäuse von 13
- 14: Wähler
- 15: Lastumschalter
- 16: Piezoelement
- 17: Kabel
- 18: Auswerteeinrichtung
- 19, 19': Mindestfüllstand von 11, 11'
- 20: Aktivteil
- 21: Antenne
- 22: Temperatursensor
- 23: oberes Gehäuseteil von 121
- 231: Gehäusekopf von 23
- 24: mittleres Gehäuseteil von 121
- 25: unteres Gehäuseteil von 121
- 251/252/253: Kragen/Anschlag/Antennenhalterung von 25
- 26: Kabeldurchführung
- 27: äußere Abschirmelement
- 28: innere Abschirmelemente
- 29: Halteringe
- 30: O-Ringe
- 31: Stützring

## Patentansprüche

1. Messgerät (12) zum Überwachen eines Elektrogeräts (10, 13), das ein mit Isolieröl (11, 11') gefülltes oder befüllbares Gehäuse (101, 131) umfasst, das Messgerät (12) umfassend
- ein Piezoelement (16), das in dem Gehäuse (101, 131) auf Höhe eines Mindestfüllstands (19, 19') des Isolieröls (11, 11') angeordnet werden kann; und
- eine Auswerteeinrichtung (18), die an das Piezoelement (16) angeschlossen ist;
wobei
- die Auswerteeinrichtung (18) derart ausgebildet ist, dass sie
• das Piezoelement (16) zu einer Schwingung anregen kann;
• den Messwert einer von dem Füllstand abhängigen Messgröße der Schwingung, insbesondere die Halbwertszeit der Amplitude der Schwingung, ermitteln kann;
wobei
- die Auswerteeinrichtung (18) derart ausgebildet ist, dass sie zur akustischen Überwachung des Elektrogeräts (10, 13)
• während zumindest eines Teils des Zeitintervalls, in dem sie das Piezoelement (16) nicht anregt, die Schwingung des Piezoelements (16) erfasst.

2. Messgerät (12) nach dem vorigen Anspruch, umfassend
- eine Antenne (21), die in dem Gehäuse (101, 131) angeordnet und an die Auswerteeinrichtung (18) angeschlossen ist.

3. Messgerät (12) nach einem der vorigen Ansprüche, umfassend
- einen Temperatursensor (22), der in dem Gehäuse (101, 131) angeordnet werden kann und an die Auswerteeinrichtung (18) angeschlossen ist.

4. Messgerät (12) nach einem der vorigen Ansprüche, wobei
- das Piezoelement (16) zusammen mit der Antenne (21) und/oder dem Temperatursensor (22) in einem gemeinsamen Messgehäuse (121) angeordnet ist.

5. Messgerät (12) nach einem der vorigen Ansprüche, wobei
- das Piezoelement (16) eine Oberseite hat, die zumindest teilweise konvex ist und/oder zumindest teilweise plan und nicht waagerecht ist und/oder zumindest teilweise plan und waagerecht ist und/oder zumindest teilweise konkav ist und/oder wenigstens oder genau einen Ablauf für Isolieröl (11, 11') aufweist.

6. Elektrogerät (10, 13), insbesondere Leistungstransformator (13), Kompensationsdrossel oder Laststufenschalter (10), umfassend
- ein mit Isolieröl (11,11') gefülltes oder befüllbares Gehäuse (101, 131); und
- ein Messgerät (12), das gemäß Anspruch 1 ausgebildet ist.

7. Elektrogerät (10, 13) nach dem vorigen Anspruch, wobei
- die Auswerteeinrichtung (18) des Messgeräts (12) derart ausgebildet ist, dass sie zur Überwachung des Mindestfüllstands (19, 19') des Isolieröls (11, 11') in dem Gehäuse (101, 131) des Elektrogeräts (10, 13)
• den Messwert der vom Füllstand abhängigen Messgröße der Schwingung des Piezoelements (16) des Messgeräts (12) mit einem vorbestimmten Schwellenwert vergleicht und
• falls der Messwert größer als dieser Schwellenwert ist, ein Alarmsignal erzeugt.

8. Elektrogerät (10, 13) nach einem der Ansprüche 6 und 7, wobei
- die Auswerteeinrichtung (18) des Messgeräts (12) außerhalb des Gehäuses (101, 131) des Elektrogeräts (10, 13) oder neben dem Gehäuse (101, 131) des Elektrogeräts (10,13) angeordnet ist.

9. Elektrogerät (10,13) nach einem der Ansprüche 6 bis 8, wobei
- das Piezoelement (16) des Messgeräts (12) an der Unterseite eines Deckels des Gehäuses (101, 131) des Elektrogeräts (10, 13) angebracht ist.

10. Elektrogerät (10, 13) nach einem der Ansprüche 6 bis 9, wobei
- das Messgerät (12)
• eine Antenne (21) umfasst, die in dem Gehäuse (101, 131) des Elektrogeräts (10, 13) angeordnet und an die Auswerteeinrichtung (18) des Messgeräts (12) angeschlossen ist.

11. Elektrogerät (10, 13) nach dem vorigen Anspruch, wobei
- die Auswerteeinrichtung (18) des Messgeräts (12) derart ausgebildet ist, dass sie zur Entladungsüberwachung
• die Amplitude des von der Antenne (21) des Messgeräts (12) erzeugten Antennensignals mit einem vorbestimmten Schwellenwert vergleicht; und
• falls die Amplitude des Antennensignals größer als dieser Schwellenwert ist, ein Alarmsignal erzeugt.

12. Elektrogerät (10, 13) nach dem vorigen oder vorvorigen Anspruch, wobei
- die Auswerteeinrichtung (18) des Messgeräts (12) derart ausgebildet ist, dass sie zur Entladungslokalisation
• die Amplitude des von der Antenne (21) des Messgeräts (12) erzeugten Antennensignals mit einem vorbestimmten Schwellenwert vergleicht; und
• falls die Amplitude des Antennensignals größer als dieser Schwellenwert ist, die Schwingung des Piezoelements (16) des Messgeräts (12) erfasst.

13. Elektrogerät (10, 13) nach dem vorigen Anspruch, wobei
- die Auswerteeinrichtung (18) des Messgeräts (12) derart ausgebildet ist, dass sie
• die Amplitude der Schwingung des Piezoelements (16) des Messgeräts (12) mit einem vorbestimmten Schwellenwert vergleicht; und
• falls die Amplitude der Schwingung größer als dieser Schwellenwert ist, eine Laufzeit als Differenz zwischen dem Zeitpunkt, zu dem die Amplitude der Schwingung größer als der zugeordnete Schwellenwert ist, und dem Zeitpunkt, zu dem die Amplitude des Antennensignals größer als der zugeordnete Schwellenwert ist, ermittelt und aus dieser Laufzeit ein Lokalisationssignal erzeugt.

14. Elektrogerät (10, 13) nach einem der Ansprüche 6 bis 13, wobei
- die Anregung des Piezoelements (16) des Messgeräts (12) bei dessen Resonanzfrequenz erfolgt.

15. Verfahren zum Überwachen eines Elektrogeräts (10, 13), das gemäß einem der Ansprüche 6 bis 14 ausgebildet ist und
- ein mit Isolieröl (11, 11') gefülltes oder befüllbares Gehäuse (101, 131); und
- ein Messgerät (12) umfasst, das
• gemäß einem der Ansprüche 1 bis 5 ausgebildet ist und
• ein Piezoelement (16) umfasst, das in dem Gehäuse (101, 131) des Elektrogeräts (10, 13) auf Höhe eines Mindestfüllstands (19, 19') des Isolieröls (11, 11') angeordnet ist;
umfassend die Schritte, dass
- das Piezoelement (16) zu einer Schwingung angeregt wird;
- der Messwert einer von dem Füllstand abhängigen Messgröße der Schwingung, insbesondere die Halbwertszeit der Amplitude der Schwingung, ermittelt wird;
wobei
- zur akustischen Überwachung des Elektrogeräts (10, 13) während zumindest eines Teils des Zeitintervalls, in dem das Piezoelement (16) nicht angeregt wird, die Schwingung des Piezoelements (16) erfasst wird.

## Claims

1. A measuring device (12) for monitoring an electrical device (10, 13), which comprises a housing (101, 131) filled or fillable with insulation oil (11, 11'), the measuring device (12) comprising
- a piezo element (16), which can be arranged in the housing (101, 131) on a level with a minimum filling level (19, 19') of the insulation oil (11, 11'); and
- an evaluation device (18), which is connected to the piezo element (16);
wherein
- the evaluation device (18) is formed such that
• it can induce an oscillation of the piezo element (16); and
• it can determine the measurement value of a measurand of the oscillation, in particular the half-life of the amplitude of the oscillation, with the measurand being dependent on the filling level;
wherein
- for the purpose of acoustically monitoring the electrical device (10, 13), the evaluation device (18) is formed such that
• it detects the oscillation of the piezo element (16) at least during a part of the time interval in which the evaluation device (18) is not inducing oscillation of the piezo element (16).

2. The measuring device (12) according to the previous claim, comprising
- an antenna (21), which is arranged in the housing (101, 131) and connected to the evaluation device (18).

3. The measuring device (12) according to one of the previous claims, comprising
- a temperature sensor (22), which can be arranged in the housing (101, 131) and which is connected to the evaluation device (18).

4. The measuring device (12) according to one of the previous claims wherein
- the piezo element (16) is arranged together with the antenna (21) and/or with the temperature sensor (22) in a common measuring housing (121).

5. The measuring device (12) according to one of the previous claims wherein
- the piezo element (16) has an upper side, which is at least partly convex and/or which is at least partly planar and not horizontal and/or which is at least partly planar and horizontal and/or which is at least partly concave and/or which has at least or exactly one outlet for insulation oil (11, 11').

6. An electrical device (10, 13), in particular a power transformer (13), a shunt reactor, or an on-load tap changer (10), comprising
- a housing (101, 131) filled or fillable with insulation oil (11, 11'); and
- a measuring device (12) formed according to claim 1.

7. The electrical device (10, 13) according to the previous claim wherein,
- for the purpose of monitoring the minimum filling level (19, 19') of the insulation oil (11, 11') in the housing (101, 131) of the electrical device (10, 13), the evaluation device (18) of the measuring device (12) is formed such that
• it compares the measurement value of a measurand of the oscillation of the piezo element (16) with the measurand being dependent on the filling level with a predetermined threshold value; and
• it generates an alarm signal if the measurement value is greater than said threshold value.

8. The electrical device (10, 13) according to one of the claims 6 and 7, wherein
- the evaluation device (18) of the measuring device (12) is arranged outside of the housing (101, 131) of the electrical device (10, 13) or next to the housing (101, 131) of the electrical device (10, 13).

9. The electrical device (10, 13) according to one of the claims 6 to 8, wherein
- the piezo element (16) of the measuring device (12) is arranged on the underside of a cover of the housing (101, 131) of the electrical device (10, 13).

10. The electrical device (10, 13) according to one of the claims 6 to 9, wherein
- the measuring device (12) comprises
• an antenna (21), which is arranged in the housing (101, 131) of the electrical device (10, 13) and is connected to the evaluation device (18) of the measuring device (12).

11. The electrical device (10, 13) according to the previous claim wherein,
- for the purpose of discharge monitoring, the evaluation device (18) of the measuring device (12) is formed such that
• it compares the amplitude of the antenna signal generated by the antenna (21) of the measuring device (12) with a predetermined threshold value; and
• it generates an alarm signal if the amplitude of the antenna signal is greater than said threshold value.

12. The electrical device (10, 13) according to the previous claim or to the claim preceding the previous claim wherein,
- for the purpose of discharge localization, the evaluation device (18) of the measuring device (12) is formed such that
• it compares the amplitude of the antenna signal generated by the antenna (21) of the measuring device (12) with a predetermined threshold value; and
• it detects the oscillation of the piezo element (16) of the measuring device (12) if the amplitude of the antenna signal is greater than said threshold value.

13. The electrical device (10, 13) according to the previous claim wherein
- the evaluation device (18) of the measuring device (12) is formed such that
• it compares the amplitude of the oscillation of the piezo element (16) of the measuring device (12) with a predetermined threshold value; and,
• if the amplitude of the oscillation is greater than said threshold value, it determines a running time as difference between the moment when the amplitude of the oscillation is greater than the associated threshold value and the moment when the amplitude of the antenna signal is greater than the associated threshold value, and it generates a localization signal from said running time.

14. The electrical device (10, 13) according to one of the claims 6 to 13, wherein
- the inducement of oscillation of the piezo element (16) of the measuring device (12) is carried out at its resonant frequency.

15. A method for monitoring an electrical device (10, 13) that is formed according to one of the claims 6 to 14 and comprises
- a housing (101, 131) filled or fillable with insulation oil (11, 11'); and
- a measuring device (12) that is formed
• according to one of the claims 1 to 5, and comprises
• a piezo element (16) arranged in the housing (101, 131) of the electrical device (10, 13) on a level with a minimum filling level (19, 19') of the insulation oil (11, 11');
the method comprising the steps that
- an oscillation of the piezo element (16) is induced;
- the measurement value of a measurand of the oscillation is determined, in particular the half-life of the amplitude of the oscillation, with the measurand being dependent on the filling level;
wherein
- for the purpose of acoustically monitoring the electrical device (10, 13) the oscillation of the piezo element (16) is detected at least during a part of the time interval in which the piezo element (16) is not being induced to oscillate.

## Revendications

1. Appareil de mesure (12) destiné à la surveillance d'un appareil électrique (10, 13) qui comprend un boîtier (101, 131) rempli ou pouvant être rempli d'huile isolante (11, 11'), le appareil de mesure (12) comprenant
- un élément piézo (16) qui peut être disposé dans le boîtier (101, 131) à hauteur d'un niveau de remplissage minimum (19, 19') de l'huile isolante (11, 11') ; et
- un dispositif d'évaluation (18) qui est raccordé à l'élément piézo (16) ;
- le dispositif d'évaluation (18) étant conçu de façon à pouvoir
• faire vibrer l'élément piézo (16) ;
• déterminer la valeur de mesure d'une grandeur de mesure de la vibration qui dépend du niveau de remplissage, notamment la durée à mi-crête de l'amplitude de l'oscillation ;
- le dispositif d'évaluation (18) étant conçu de manière à
• détecter la vibration de l'élément piézo (16) pendant au moins une partie de l'intervalle de temps, pendant lequel il n'excite pas l'élément piézo (16), afin d'effectuer la surveillance acoustique de l'appareil électrique (10, 13).

2. Appareil de mesure (12) selon la revendication précédente, comprenant
- une antenne (21) qui est disposée dans le boîtier (101, 131) et qui est reliée au dispositif d'évaluation (18) .

3. Appareil de mesure (12) selon l'une des revendications précédentes, comprenant
- un capteur de température (22) qui peut être disposé dans le boîtier (101, 131) et qui est relié au dispositif d'évaluation (18).

4. Appareil de mesure (12) selon l'une des revendications précédentes,
- l'élément piézo (16) étant disposé conjointement avec l'antenne (21) et/ou le capteur de température (22) dans un boîtier de mesure commun (121).

5. Appareil de mesure (12) selon l'une des revendications précédentes,
- l'élément piézo (16) comportant un côté supérieur qui est au moins partiellement convexe et/ou au moins partiellement plan et non horizontal et/ou au moins partiellement plan et horizontal et/ou au moins partiellement concave et/ou au moins ou exactement une évacuation de huile isolante (11, 11').

6. Appareil électrique (10, 13), notamment transformateur de puissance (13), self de compensation ou graduateur de réglage en charge (10), comprenant
- un boîtier (101, 131) rempli ou pouvant être rempli d'huile isolante (11, 11') ; et
- un appareil de mesure (12) qui est conçu selon la revendication 1.

7. Appareil électrique (10, 13) selon la revendication précédente,
- le dispositif d'évaluation (18) de l'appareil de mesure (12) étant conçu pour
• comparer la valeur de mesure de la grandeur de mesure, qui dépend du niveau de remplissage, de la vibration de l'élément piézo (16) de l'appareil de mesure (12) à une valeur seuil prédéterminée et
• générer un signal d'alarme si la valeur de mesuré est supérieure à cette valeur seuil,
afin de surveiller le niveau de remplissage minimum (19, 19') de l'huile isolante (11, 11') dans le boîtier (101, 131) de l'appareil électrique (10, 13).

8. Appareil électrique (10, 13) selon l'une des revendications 6 et 7,
- le dispositif d'évaluation (18) de l'appareil de mesure (12) est disposé à l'extérieur du boîtier (101, 131) de l'appareil électrique (10, 13) ou à côté du boîtier (101, 131) de l'appareil électrique (10, 13).

9. Appareil électrique (10, 13) selon l'une des revendications 6 à 8,
- l'élément piézo (16) de l'appareil de mesure (12) étant fixé sur le côté inférieur d'un couvercle du boîtier (101, 131) de l'appareil électrique (10, 13).

10. Appareil électrique (10, 13) selon l'une des revendications 6 à 9,
- l'appareil de mesure (12) comprend
• une antenne (21) qui est disposée dans le boîtier (101, 131) de l'appareil électrique (10, 13) et qui est raccordée au dispositif d'évaluation (18) de l'appareil de mesure (12).

11. Appareil électrique (10, 13) selon la revendication précédente,
- le dispositif d'évaluation (18) de l'appareil de mesure (12) étant conçu pour
• comparer l'amplitude du signal d'antenne, généré par l'antenne (21) de l'appareil de mesure (12), à une valeur seuil prédéterminée ; et
• générer un signal d'alarme si l'amplitude du signal d'antenne est supérieure à ce seuil,
afin de surveiller la décharge.

12. Appareil électrique (10, 13) selon la dernière ou avant-dernière revendication,
- le dispositif d'évaluation (18) de l'appareil de mesure (12) étant conçu pour
• comparer l'amplitude du signal d'antenne, généré par l'antenne (21) de l'appareil de mesure (12), à une valeur seuil prédéterminée ; et
• détecter la vibration de l'élément piézo (16) de l'appareil de mesure (12) si l'amplitude du signal d'antenne est supérieure à cette valeur seuil,
afin de localiser la décharge.

13. Appareil électrique (10, 13) selon la revendication précédente,
- le dispositif d'évaluation (18) de l'appareil de mesure (12) étant conçu de façon à
• comparer l'amplitude de l'oscillation de l'élément piézo (16) du dispositif de mesure (12) à une valeur seuil prédéterminée ; et
• si l'amplitude de l'oscillation est supérieure à cette valeur seuil, déterminer un temps de propagation comme différence entre l'instant, auquel l'amplitude de l'oscillation est supérieure à la valeur seuil associée, et l'instant, auquel l'amplitude du signal d'antenne est supérieure à la valeur seuil associée, et générer un signal de localisation à partir de ce temps de propagation.

14. Appareil électrique (10, 13) selon l'une des revendications 6 à 13,
- l'excitation de l'élément piézo (16) du dispositif de mesure (12) étant effectuée à la fréquence de résonance de celui-ci.

15. Procédé de surveillance d'un appareil électrique (10, 13), qui est conçu selon l'une des revendications 6 à 14 et comprend
- un boîtier (101, 131) rempli ou pouvant être rempli d'huile isolante (11, 11') ; et
- un appareil de mesure (12) qui
• est conçu selon l'une des revendications 1 à 5 et
• comprend un élément piézo (16) qui est disposé dans le boîtier (101, 131) de l'appareil électrique (10, 13) à hauteur d'un niveau de remplissage minimum (19, 19') de l'huile isolante (11, 11') ;
ledit procédé comprenant les étapes suivantes :
- exciter l'élément piézo (16) pour le faire vibrer ;
- déterminer la valeur de mesure d'une grandeur de mesure de l'oscillation, qui dépend du niveau de remplissage, notamment la durée à mi-crête de l'amplitude de l'oscillation ;
- détecter l'oscillation de l'élément piézo (16) afin d'effectuer la surveillance acoustique de l'appareil électrique (10, 13) pendant au moins une partie de l'intervalle de temps pendant lequel l'élément piézo (16) n'est pas excité.
